# EUROPEAN PATENT APPLICATION

(11) **EP 3 396 457 A1**
(43) Date of publication of application: **31.10.2018**
(21) Application number: 17168204.0
(22) Date of filing: 26.04.2017
(51) Int. Cl.: G03F 7/20

(54) **DEVICE MANUFACTURING METHOD**

(71) Applicant: ASML Netherlands B.V., 5500 AH Veldhoven (NL)
(72) Inventor: SIMONS, Hubertus, Johannes, Gertrudus, 5500 AH Veldhoven (NL); MOS, Everhardus, Cornelis, 5500 AH Veldhoven (NL)
(74) Representative: Peters, John Antoine

(57) **Abstract**

A device manufacturing method comprising:
exposing a first substrate using a lithographic apparatus to form a patterned layer comprising first features;
processing the first substrate to transfer the first features into the first substrate;
determining displacements of the first features from their nominal positions in the first substrate;
determining a correction to at least partly compensate for the displacements; and
exposing a second substrate using a lithographic apparatus to form a patterned layer comprising the first features;
wherein the correction is applied during the exposing the second substrate.

## Description

### BACKGROUND

### Field of the Invention

The present invention relates to device manufacturing using lithographic apparatus.

### Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

Most semiconductor devices require a plurality of pattern layers to be formed and transferred into the substrate. For proper functioning of the device, there is usually a limit on the tolerable positioning error (known in the art as overlay) between successive layers. With the continual desire in the lithographic art to reduce the size of features that can be formed (shrink) the limits on overlay are becoming stricter.

Overlay can arise from a variety of causes in the lithographic process, for example errors in the positioning of the substrate during exposure and aberrations in the projected image. Overlay can also be caused during process steps, such as etching, which are used to transfer the pattern into the substrate. Some such process steps generate stresses within the substrate that lead to local or global distortions of the substrate. The formation of three dimensional structures on the substrate, such as is required for recently developed memory types and MEMS, can also lead to significant distortions of the substrate.

### SUMMARY OF THE INVENTION

The present invention aims to provide improved lithographic device manufacturing processes which can address process-induced distortions.

The invention in a first aspect provides a device manufacturing method comprising:
exposing a first substrate using a lithographic apparatus to form a patterned layer comprising first features;
processing the first substrate to transfer the first features into the first substrate;
determining displacements of the first features from their nominal positions in the first substrate;
determining a correction to at least partly compensate for the displacements; and
exposing a second substrate using a lithographic apparatus to form a patterned layer comprising the first features;
wherein the correction is applied during the exposing the second substrate.

### BRIEF DESCRIPTION OF THE DRAWINGS/FIGURES

Embodiments of the invention will now be described, by way of example, with reference to the accompanying drawings in which:
Figure 1 depicts a lithographic apparatus together with other apparatuses forming a production facility for semiconductor devices;
Figure 2 depicts a flow chart of a method according to an embodiment of the invention;
Figure 3 depicts a substrate having a grid of features printed thereon;
Figure 4 depicts a substrate having a grid of features depicted thereon after process-induced distortion; and
Figure 5 depicts a substrate on which a grid of features is printed at adapted positions.

### DETAILED DESCRIPTION

Before describing embodiments of the invention in detail, it is instructive to present an example environment in which embodiments of the present invention may be implemented.

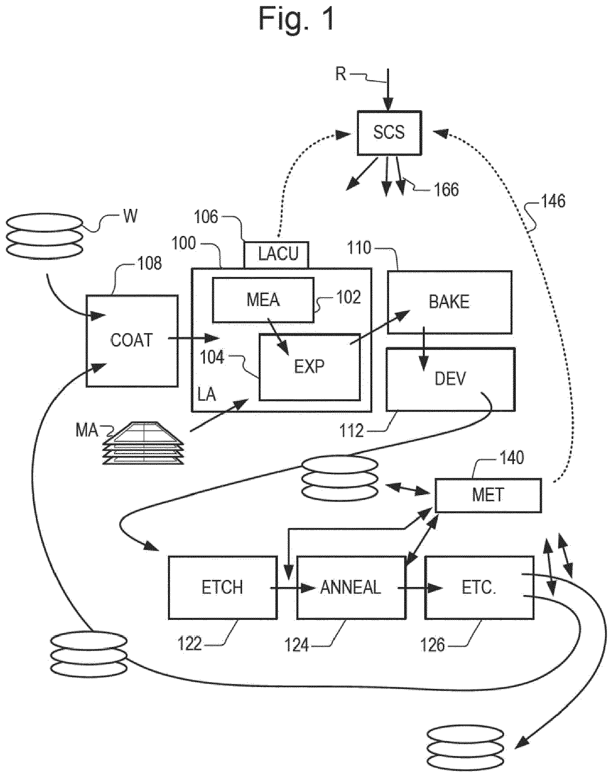

Figure 1 illustrates a typical layout of a semiconductor production facility. A lithographic apparatus 100 applies a desired pattern onto a substrate. A lithographic apparatus is used, for example, in the manufacture of integrated circuits (ICs). In that instance, a patterning device MA, which is alternatively referred to as a mask or a reticle, comprises a circuit pattern of features (often referred to as "product features") to be formed on an individual layer of the IC. This pattern is transferred onto a target portion (e.g., comprising part of, one, or several dies) on a substrate 'W' (e.g., a silicon wafer) via exposure 104 of the patterning device onto a layer of radiation-sensitive material (resist) provided on the substrate. In general, a single substrate will contain a network of adjacent target portions that are successively patterned.

Known lithographic apparatus irradiate each target portion by illuminating the patterning device while synchronously positioning the target portion of the substrate at an image position of the patterning device. An irradiated target portion of the substrate is referred to as an "exposure field", or simply "field". The layout of the fields on the substrate is typically a network of adjacent rectangles aligned in accordance to a Cartesian two-dimensional coordinate system (e.g. aligned along an X and an Y-axis, both axes being orthogonal to each other).

A requirement on the lithographic apparatus is an accurate reproduction of the desired pattern onto the substrate. The positions and dimensions of the applied product features need to be within certain tolerances. Position errors may occur due to an overlay error (often referred to as "overlay"). The overlay is the error in placing a first product feature within a first layer relative to a second product feature within a second layer. The lithographic apparatus minimizes the overlay errors by aligning each wafer accurately to a reference prior to patterning. This is done by measuring positions of alignment marks which are applied to the substrate. Based on the alignment measurements the substrate position is controlled during the patterning process in order to prevent occurrence of overlay errors. Alignment marks are typically created as part of the product image forming the reference to which overlay is measured. Alternatively alignment marks of a previously formed layer can be used.

An error in a critical dimension (CD) of the product feature may occur when the applied dose associated with the exposure 104 is not within specification. For this reason the lithographic apparatus 100 must be able to accurately control the dose of the radiation applied to the substrate. CD errors may also occur when the substrate is not positioned correctly with respect to a focal plane associated with the pattern image. Focal position errors are commonly associated with non-planarity of a substrate surface. The lithographic apparatus minimizes these focal positon errors by measuring the substrate surface topography using a level sensor prior to patterning. Substrate height corrections are applied during subsequent patterning to assure correct imaging (focusing) of the patterning device onto the substrate.

To verify the overlay and CD errors associated with the lithographic process the patterned substrates are inspected by a metrology apparatus 140. A common example of a metrology apparatus is a scatterometer. The scatterometer conventionally measures characteristics of dedicated metrology targets. These metrology targets are representative of the product features, except that their dimensions are typically larger in order to allow accurate measurement. The scatterometer measures the overlay by detecting an asymmetry of a diffraction pattern associated with an overlay metrology target. Critical dimensions are measured by analysis of a diffraction pattern associated with a CD metrology target. A CD metrology target is used for measuring the result of the most recently exposed layer. An overlay target is used for measuring the difference between the positions of the previous and most recent layers. Another example of a metrology tool is an electron beam (e-beam) based inspection tool such as a scanning electron microscope (SEM).

Within a semiconductor production facility, lithographic apparatus 100 and metrology apparatus 140 form part of a "litho cell" or "litho cluster". The litho cluster comprises also a coating apparatus 108 for applying photosensitive resist to substrates W, a baking apparatus 110, a developing apparatus 112 for developing the exposed pattern into a physical resist pattern, an etching station 122, apparatus 124 performing a post-etch annealing step and possibly further processing apparatuses, 126, etc.. The metrology apparatus is configured to inspect substrates after development (112) or after further processing (e.g. etching). The various apparatus within the litho cell are controlled by a supervisory control system SCS, which issues control signals 166 to control the lithographic apparatus via lithographic apparatus control unit LACU 106 to perform recipe R. The SCS allows the different apparatuses to be operated giving maximum throughput and product yield. An important control mechanism is the feedback 146 of the metrology apparatus 140 to the various apparatus (via the SCS), in particular to the lithographic apparatus 100. Based on the characteristics of the metrology feedback corrective actions are determined to improve processing quality of subsequent substrates.

The performance of a lithographic apparatus is conventionally controlled and corrected by methods such as advanced process control (APC) described for example in US2012008127A1. The advanced process control techniques use measurements of metrology targets applied to the substrate. A Manufacturing Execution System (MES) schedules the APC measurements and communicates the measurement results to a data processing unit. The data processing unit translates the characteristics of the measurement data to a recipe comprising instructions for the lithographic apparatus. This method is very effective in suppressing drift phenomena associated with the lithographic apparatus.

The processing of metrology data to corrective actions performed by the processing apparatus is important for semiconductor manufacturing. In addition to the metrology data also characteristics of individual patterning devices, substrates, processing apparatus and other context data may be needed to further optimize the manufacturing process. The framework wherein available metrology and context data is used to optimize the lithographic process as a whole is commonly referred to as part of holistic lithography. For example context data relating to CD errors on a reticle may be used to control various apparatus (lithographic apparatus, etching station) such that said CD errors will not affect the yield of the manufacturing process. Subsequent metrology data may then be used to verify the effectiveness of the control strategy and further corrective actions may be determined.

In the manufacture of semiconductor devices, accuracy of layer-to-layer positioning is important and limitations on tolerable overlay are becoming ever stricter with the continual desire in the industry to form smaller features. A variety of control and compensation systems exist to minimize overlay, especially overlay due to causes internal to the lithographic apparatus. In addition, overlay can be caused by process steps such as etching, deposition, polishing (CMP) and annealing. These, and potentially other, process steps can cause global and local distortions of the substrate, especially if the substrate is stressed when the process step is performed. It is difficult to control and reduce these distortions.

It is known to measure distortions of a substrate, e.g. by measuring the relative positions of alignment marks, after a process step and to apply corrections in the patterning of subsequent layers on that substrate. In effect, subsequent layers are deliberately shifted and/or distorted to match the distortion caused on previous layers by the process steps. The resulting distortions in the finished device are usually not critical to its functioning in the way that misalignment of layers would be.

Although this known form of feedback control can be effective in many circumstances, with many layers and correspondingly many process steps the distortions accumulate and become more complex. Accordingly, the necessary corrections may exceed the capabilities of the lithographic apparatus. In many cases not all layers of a device are equally critical and so different layers of a device may be imaged using different types of lithographic apparatus. The different lithographic apparatus may not all have the same capabilities to apply pattern corrections to compensate for overlay. Therefore, the known feedback control mechanism may not be able to provide adequate compensation for process-induced distortions in all circumstances.

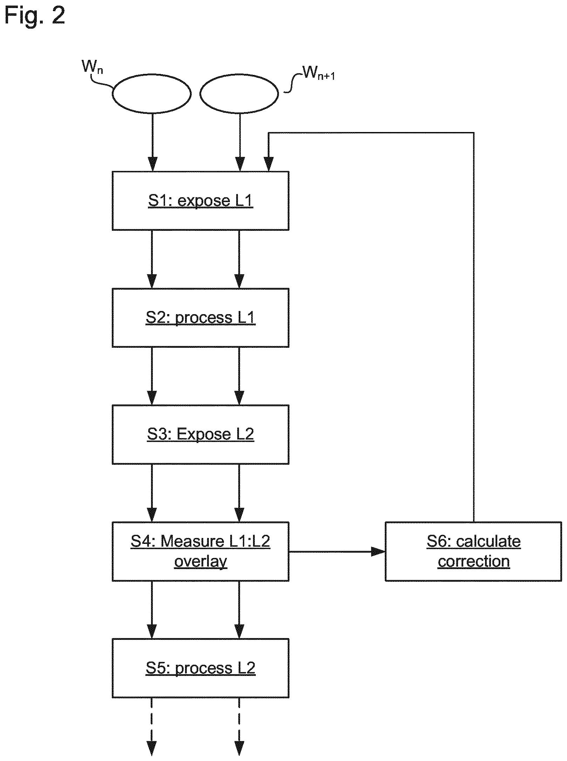

A process according to an embodiment of the present invention is depicted in Figure 2 of the accompanying drawings. A first substrate Wₙ is exposed S1 to form first layer L1 and processed S2 to transfer layer 1 into the substrate. The process step S2 may be, for example, an etch, a deposition, a polish or an annealing step. As discussed above, the process step S2 distorts the substrate Wₙ and therefore shifts the positions of features formed on the substrate from their nominal positions. Based on measuring the distortions in first layer L1 using alignment markers, a second layer L2 is exposed S3. Overlay between L1 and L2 is measured S4 in a known manner, e.g. using overlay marks with respective parts included within first layer L1 and second layer L2. The second layer L2 is then transferred into the substrate by process step S5. Measurement step S4 can be performed using a stand-alone measurement tool, such as a scatterometer. By measuring overlay in a standalone measurement tool, it is possible to obtain very precise measurements, from which displacements of the first features can be derived, without a detrimental effect on throughput. Further exposure and process steps are carried out as necessary to complete the devices.

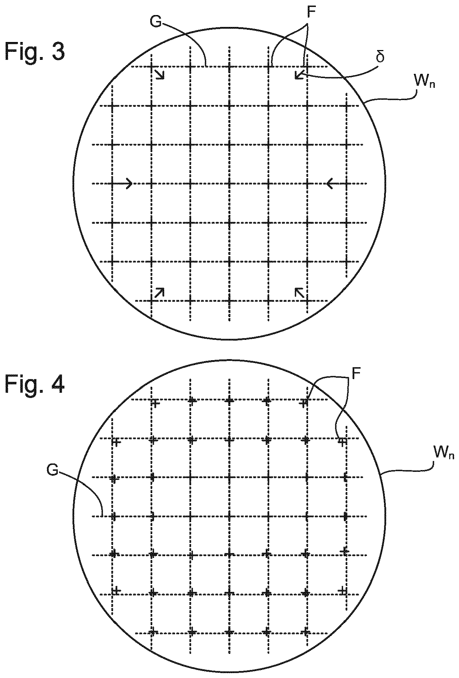

According to an embodiment of the invention, the measurement results from measure step S4 are used to calculate a correction to be applied in the exposure of the first layer L1 of one or more subsequent substrates Wₙ₊₁. The effect of the correction which is applied in the exposure of the first layer L1 of a subsequent substrate is that at least some of the features of the first layer L1 are imaged onto the subsequent substrate Wₙ₊₁ at adapted positions which are displaced from their nominal positions. The adapted positions are determined based on the results of measurement step S4 from the previous substrate Wₙ so that after the distortions caused in process step S2, the features will end up at, or closer to, their nominal positions. This is explained further with reference to Figures 3 to 5.

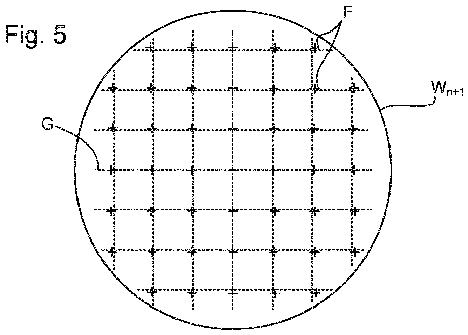

Figure 3 depicts a substrate W on which a plurality of features F are formed. On exposure, features F are aligned on a virtual grid G, which is shown only for illustrative purposes. The grid G can be regarded as representing the coordinate system of the lithographic apparatus. Process step S2 distorts the substrate resulting in shifts of the actual positions of the features F as indicated by the arrows δ. Thus, after the process step S2, the substrate Wₙ looks as shown in Figure 4 where the features F are displaced from their nominal positions relative to the grid G. The displacements δ are determined in measurement step S4 (e.g. from measurements of overlay between L1 and L2 on Wₙ) so that the features F when imaged on to substrate Wₙ₊₁ can be placed at adapted positions, displaced from the grid G as shown in Figure 5. This means that after process step S2 is carried out on substrate Wₙ₊₁ the features F will be displaced back to, or at least closer to, their nominal positions on the grid G.

By applying a precompensation to the first layer L1 of the subsequent substrates Wₙ₊₁ for the distortions expected to be caused by process step S2, the need to apply compensation in the exposure of subsequent layers L2 in the subsequent substrates Wₙ₊₁, is reduced or eliminated. This means that the necessary compensations do not accumulate as the various layers required to construct the device are formed and so the problem of the necessary compensations exceeding the capabilities of the lithographic apparatus used for the subsequent layers is avoided.

Calculation of the precompensation to be applied to the first layer L1 in the subsequent substrates can be performed using the same approaches that have heretofore been used to calculate corrections to be applied in subsequent layers on the same substrate.

It will be noted that the distortions illustrated in Figures 3 to 5 are grossly exaggerated for illustrative purposes, the actual distortions occurring being of the order of nanometers. In addition, the distortion shown is a fairly simply shrinkage of the substrate whereas actual distortions occurring in use may be much more complex. Distortion can occur at inter-field scales as well as intra-field scales and can be very complex. The distortions may also involve out of plane deformations of the substrate as well as in-plane deformations.

It is not often possible to directly measure the displacements of the product features F whose placement is most critical since the markers used to measure distortions of the substrate cannot be placed exactly at the same positions as the product features F. Nevertheless, sufficient markers can be included within the pattern layers to enable the displacements of the product features F to be modelled across the area of the substrate. Markers can be provided that are designed so as to experience similar distortions as product features F.

First layer L1 need not be the very first layer that is formed on the substrate in the device manufacturing process. Nevertheless, in many product designs it is the first few layers that are formed that are most critical so that use of the invention within the first few layers provides the greatest advantage. Reducing the corrections deriving from the earliest layers has the greatest effect in preventing such corrections accumulating as more layers are formed.

The present invention can be applied to multiple layers of the device. For example, precompensation is applied to layer L1 to address distortions that are expected in process step S2. Although this means that the exposure of layer L2 need include no or a reduced correction for the distortions of process step S2, it is then possible to introduce precompensation into the exposure of second layer L2 to address expected distortions from process step S5 which transfers layer L2 into the substrate. The same applies to later layers.

In the embodiment described above, the corrections are calculated on the basis of measurements of a preceding substrate. In the event that the effects of the process step are stable over time, it may be that measurements of only the first substrate in a batch need be performed and the same calculated corrections can be applied to all subsequent substrates in that or subsequent batches. However, if the distortions caused by the process step have a random component, it may be desirable to measure multiple substrates and base the corrections on an average or other statistical treatment of the measurement results. If the effect of the process step has a component which drifts over time, it may be desirable to base the corrections to be applied to a given substrate on measurements that are derived from an immediately preceding substrate. Due to the time taken for processing layer L1, exposing the second layer L2 and L1:L2 overlay measurements, in many cases the corrections applied to a given substrate will be derived from a preceding lot or batch of substrates. In some cases the precompensation may not perfectly correct the distortion introduced by the process step in which case the residual distortion can be measured and the precompensation improved for subsequent substrates. Combinations of these approaches are possible and an appropriate sampling scheme can be determined for a given process step and process apparatus taking into account its characteristics.

Embodiments of the present invention can be used to reduce the corrections that need to be employed in subsequent layers formed on a substrate in magnitude and/or complexity. This improvement avoids or reduces the accumulation of complex corrections, which has several advantages. For example, since the distortions of subsequent layers are reduced in magnitude and/or complexity, those distortions can be measured with fewer measurements or can be measured with greater accuracy using the same number of measurements. Fewer measurements can improve throughput and/or may reduce the space on the substrate that is given over to markers rather than product features. If only simple corrections need to be applied, it may be possible to image subsequent layers using less advanced lithographic apparatus, whereas without the precompensation of the invention, an advanced lithographic apparatus might be required to apply corrections, even if the criticality of the subsequent layers did not require use of an advanced lithographic apparatus.

While specific embodiments of the invention have been described above, it will be appreciated that the invention may be practiced otherwise than as described.

An embodiment may include a computer program containing one or more sequences of machine-readable instructions configured to instruct various apparatus as depicted in Figure 1 to perform measurement and optimization steps and to control a subsequent exposure process as described above. This computer program may be executed, for example, within the control unit LACU or the supervisory control system SCS of Figure 1 or a combination of both. There may also be provided a data storage medium (e.g., semiconductor memory, magnetic or optical disk) having such a computer program stored therein.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams. Implementations of scatterometers and other inspection apparatus can be made in UV and EUV wavelengths using suitable sources, and the present disclosure is in no way limited to systems using IR and visible radiation.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A device manufacturing method comprising:
exposing a first substrate using a lithographic apparatus to form a patterned layer comprising first features;
processing the first substrate to transfer the first features into the first substrate;
determining displacements of the first features from their nominal positions in the first substrate;
determining a correction to at least partly compensate for the displacements; and
exposing a second substrate using a lithographic apparatus to form a patterned layer comprising the first features;
wherein the correction is applied during the exposing the second substrate.

2. A method according to claim 1 wherein determining displacements of the first features comprises:
exposing the first substrate using the lithographic apparatus to form a second patterned layer comprising second features; and
measuring overlay on the first substrate between the first and second features.

3. A method according to any one of the preceding claims further comprising:
processing the second substrate to transfer the first features into the second substrate;
measuring displacements of the first features from their nominal positions in the second substrate;
determining a residual correction to compensate for any residual displacement of the first features in the second substrate;
exposing the second substrate using a lithographic apparatus to form a second patterned layer comprising second features, whilst applying the residual correction.

4. A method according to claim 3 wherein exposing the second substrate to form a first patterned layer is performed using a first lithographic apparatus and exposing the second substrate to form a second patterned layer is performed using a second lithographic apparatus, the second lithographic apparatus being of a different type than the first lithographic apparatus.

5. A method according to any one of the preceding claims further comprising:
processing the second substrate to transfer the first features into the second substrate;
determining displacements of the first features from their nominal positions in the second substrate;
determining a residual correction to compensate for any residual displacement of the first features in the second substrate;
using the residual correction to improve the correction;
exposing a third substrate using a lithographic apparatus to form a patterned layer comprising the first features;
wherein the improved correction is applied during the exposing the third substrate.

6. A method according to any one of the preceding claims further comprising:
processing the second substrate to transfer the first features into the second substrate;
exposing the second substrate using a lithographic apparatus to form a second patterned layer comprising second features;
processing the second substrate to transfer the second features into the second substrate;
determining second displacements of the second features from their nominal positions in the second substrate;
determining a second correction to at least partly compensate for the second displacements; and
exposing a third substrate using a lithographic apparatus to form a patterned layer comprising the second features;
wherein the second correction is applied during the exposing the third substrate.
A method according to any one of the preceding claims wherein the processing comprises one of etching, deposition, polishing (CMP) and annealing.
